(19) Europäisches Patentamt
European Patent Office
Office européen des brevets

(11) **EP 3 667 332 A1**

(12) **EUROPEAN PATENT APPLICATION**

(43) Date of publication:
**17.06.2020 Bulletin 2020/25**

(51) Int Cl.:
*G01P 21/00* *(2006.01)*     *G01C 25/00* *(2006.01)*

(21) Application number: **18306670.3**

(22) Date of filing: **11.12.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **NXP USA, Inc.
Austin TX 78735 (US)**

(72) Inventors:
• **HOLBEIN, Marc Edward
  5656 AG Eindhoven (NL)**
• **McNEIL, Andrew C
  5656 AG Eindhoven (NL)**
• **ENJALBERT, Jerome Romain
  31023 Toulouse cedex 1 (FR)**

(74) Representative: **Hardingham, Christopher Mark
NXP Semiconductors
Intellectual Property Group
Abbey House
25 Clarendon Road
Redhill, Surrey RH1 1QZ (GB)**

(54) **REDUNDANT SENSOR SYSTEM WITH SELF-TEST OF ELECTROMECHANICAL STRUCTURES**

(57)     A sensor system (20) includes first and second MEMS structures (28, 30) and a processing circuit (26). The first and second MEMS structures are configured to produce first and second output signals (64, 66), respectively, in response to a physical stimulus (23). A method (116) performed by the processing circuit entails receiving the first and second output signals and detecting a defective one of the first and second MEMS structures from the first and second output signals by determining that the first and second output signals are uncorrelated to one another. The method further entails utilizing only the first or the second output signal from a non-defective one of the MEMS structures to produce a processed output signal (72) when one of the MEMS structures is determined to be defective and utilizing the first and second output signals from both of the MEMS structures to produce the processed output signal when neither of the MEMS structures is defective.

*FIG . 1*

**Description**

## TECHNICAL FIELD OF THE INVENTION

The present invention relates generally to sensors. More specifically, the present invention relates to a sensor system and a method of testing redundant electromechanical structures of the sensor system.

## BACKGROUND OF THE INVENTION

Microelectromechanical systems (MEMS) technology has achieved wide popularity as it provides a way to make very small mechanical structures and integrate these structures with electrical devices on a single substrate using conventional batch semiconductor processing techniques. One common application of MEMS is the design and manufacture of sensor devices. MEMS sensors, such as capacitive sensor devices, are widely used in applications such as automotive, inertial guidance systems, household appliances, game devices, protection systems for a variety of devices, and many other industrial, scientific, and engineering systems.

## BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.

FIG. 1 shows in a simplified and representative form, a block diagram of a microelectromechanical systems (MEMS) sensor system;
FIG. 2 shows a block diagram of a processing circuit of the MEMS sensor system;
FIG. 3 shows a block diagram of a signal control circuit of the MEMS sensor system in a nominal operational state following self-test;
FIG. 4 shows a block diagram of the signal control circuit of the MEMS sensor system in a first reduced function state following self-test;
FIG. 5 shows a block diagram of the signal control circuit of the MEMS sensor system in a second reduced function state following self-test;
FIG. 6 shows a block diagram of a packaged MEMS sensor system in accordance with an embodiment;
FIG. 7 shows a block diagram of a packaged MEMS sensor electrically coupled with an end-user circuit; and
FIG. 8 shows a flowchart of a method of testing redundant MEMS structures in a MEMS sensor system in accordance with another embodiment.

## DETAILED DESCRIPTION

In overview, the present disclosure concerns redundant sensor systems and methodology for self-test of the redundant sensor systems. More particularly, a sensor system having redundant microelectromechanical systems (MEMS) structures and methodology utilize separate output signals from the MEMS structures for self-test (e.g., internal diagnostics) and for mitigation of a single point electromechanical failure in one of the MEMS structures. In the instance of a single point electromechanical failure, the system and methodology can enable a reduced functionality mode of the sensor system. The self-test methodology may function autonomously to detect the mechanical failure of one of the MEMS structures and mitigate it dynamically through reconfiguration of the analog front end of the corresponding integrated circuit to isolate the defective MEMS structure and produce a processed digital output signal indicative of the output from the non-defective MEMS structure. Thus, the methodology may be implemented in a variety of redundant sensor systems in which the functionality of a redundant sensor system may be determined, and failure mitigation may be performed, with minimal impact to cost and complexity of the redundant sensor systems.
The instant disclosure is provided to further explain in an enabling fashion at least one embodiment in accordance with the present invention. The disclosure is further offered to enhance an understanding and appreciation for the inventive principles and advantages thereof, rather than to limit in any manner the invention. The invention is defined solely by the appended claims including any amendments made during the pendency of this application and all equivalents of those claims as issued.
It should be understood that the use of relational terms, if any, such as first and second, top and bottom, and the like are used solely to distinguish one from another entity or action without necessarily requiring or implying any actual such relationship or order between such entities or actions. Furthermore, some of the figures may be illustrated using various shading and/or hatching to distinguish the different elements produced within the various structural layers. These different elements within the structural layers may be produced utilizing current and upcoming microfabrication techniques of depositing, patterning, etching, and so forth. Accordingly, although different shading and/or hatching is utilized in the illustrations, the different elements within the structural layers may be formed out of the same material.

Much of the inventive functionality and many of the inventive principles are best implemented with or in integrated circuits (ICs) including possibly application specific ICs or ICs with integrated processing or control or other structures. It is expected that one of ordinary skill, notwithstanding possibly significant effort and many design choices motivated by, for example, available time, current technology, and economic considerations, when guided by the concepts and principles disclosed herein will be readily capable of generating such ICs and structures with minimal experimentation. Therefore, in the interest of brevity and minimization of any risk of obscuring the principles and concepts according to the present invention, further discussion of such structures and ICs, if any, will be limited to the essentials with respect to the principles and concepts of the various embodiments.

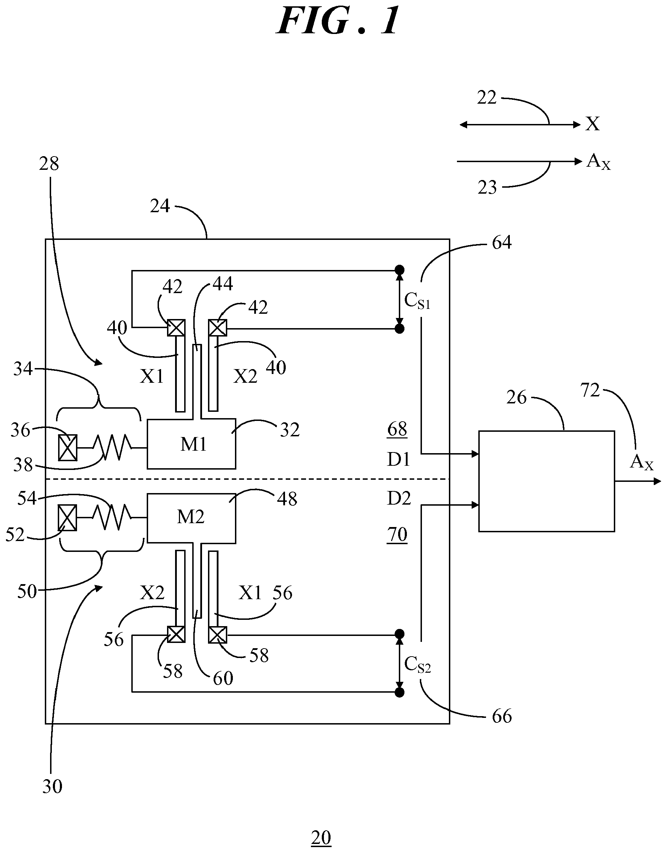

Referring to FIG. 1, FIG. 1 shows in a simplified and representative form, a block diagram of a microelectromechanical systems (MEMS) sensor system 20. For ease of explanation, sensor system 20 is adapted to sense a physical stimulus in an X-direction 22. This physical stimulus may be linear acceleration, labeled Ax and represented by an arrow 23, parallel to a major planar surface of the device. As such, sensor system 20 may be referred to hereinafter as accelerometer 20. Accelerometer 20 includes a sensor device 24 and electronic circuitry, referred to herein as a processing circuit 26, that is electrically coupled to sensor device 24.

Sensor device 24 includes a first MEMS structure 28 and a second MEMS structure 30. First MEMS structure 28 includes a first movable element 32, suspended above an underlying substrate (not shown) by one or more suspension systems 34 (one schematically shown). Each of suspension systems 34 includes a suspension anchor 36 formed on the substrate and a spring structure 38 interconnecting first movable element 32 with a corresponding suspension anchor 36. Pairs of fixed fingers 40 (one pair shown) are attached to the substrate by fixed finger anchors 42. Sense fingers 44 (one shown) extending from first movable element 32 are positioned adjacent to fixed fingers 40. Sense gaps are thus formed between sense fingers 44 and fixed fingers 40.

Likewise, second MEMS structure 30 includes a second movable element 48, suspended above the underlying substrate by one or more suspension systems 50 (one schematically shown). Each of suspension systems 50 includes a suspension anchor 52 formed on the substrate and a spring structure 54 interconnecting second movable element 48 with a corresponding suspension anchor 52. Pairs of fixed fingers 56 (one pair shown) are attached to the substrate by fixed finger anchors 58. Sense fingers 60 (one shown) extending from second movable element 48 are positioned adjacent to fixed fingers 56. Sense gaps are thus formed between sense fingers 60 and fixed fingers 56.

In some embodiments, first and second MEMS structures 28, 30 are generally identical. That is, spring structures 38, 54 have the same configuration and spring constant (within process constraints) and first and second movable elements 32, 48 have the same size, shape, and mass (within process constraints). Accordingly, both of first and second movable elements 32, 48 will behave similarly under the effect of the same physical stimulus (e.g., acceleration 23). The output signals from each of first and second MEMS structures 28, 30 can therefore be combined to obtain a measurement signal indicative of the sensed physical stimulus. Thus, accelerometer 20 may be considered a redundant sensor system. Redundant sensor configurations are increasingly being leveraged to achieve increased accuracy over a single sensor configuration and to enhance the failure tolerance of the sensor system.

In the illustrated example, each of first and second movable elements 32, 48 is configured to move in response to acceleration 23 in X-direction 22. When first movable element 32 moves in response to acceleration 23 in X-direction 22, capacitances between the moving sense fingers 44 and the fixed fingers 40 change to produce a first output signal 64, labeled $C_{S1}$. Likewise, when second movable element 48 moves in response to acceleration 23 in X-direction 22, capacitances between the moving sense fingers 60 and the fixed fingers 56 change to produce a second output signal 66, labeled $C_{S2}$. Since processing circuit 26 is electrically coupled to first and second MEMS structures 28, 30, processing circuit 26 is thus configured to receive first and second output signals 64, 66.

As discussed above, first and second MEMS structures 28 and 30 are independent from one another and act as two independent sensor channels. These independent sensor channels are referred to herein as a first channel 68 (e.g., D1) and a second channel 70 (e.g., D2). Further, they measure the same physical stimulus, e.g., acceleration 23 in X-direction 22. Thus, first and second output signals 64, 66 are generated independent from one another, but are indicative of the same physical stimulus. First output signal 64, $C_{S1}$, from first channel 68 may be represented by expression (1) and second output signal 66, $C_{S2}$, from second channel 70 may be represented by expression (2), as follows:

$$D1: C_{S1} \propto C(M1, X1) - C(M1, X2) \qquad (1)$$

$$D2: C_{S2} \propto C(M2, X1) - C(M2, X2) \tag{2}$$

Expression (1) indicates that first output signal 64, $C_{S1}$, provided by first channel 68, D1, is proportional to a difference of the capacitance, C, between sense fingers 44 of first movable element 32, M1, and first fixed fingers, X1, of each pair of fixed fingers 40 and the capacitance, C, between sense fingers 44 of first movable element 32, M1, and second fixed fingers, X2, of each pair of fixed fingers 40. Expression (2) indicates that second output signal 66, $C_{S2}$, provided by second channel 70, D2, is proportional to a difference of the capacitance, C, between sense fingers 60 of second movable element 48, M2, and first fixed fingers, X1, of each pair of fixed fingers 56 and the capacitance, C, between sense fingers 60 of second movable element 48, M2, and second fixed fingers, X2, of each pair of fixed fingers 56. The values of the independent first and second channels 68, 70 may be combined to obtain an output reading "R" of a fully differential accelerometer, as follows:

$$R \propto D1: C_{S1} - D2: C_{S2} \tag{3}$$

Expression (3) can be expanded as follows:

$$R \propto [C(M1, X1) + C(M2, X2)] - [C(M1, X2) + C(M2, X1)] \tag{4}$$

Processing circuit 26 generally includes a signal chain that functions to process first and second output signals 64, 66 from the independent first and second channels 68, 70 to produce a processed output signal 72, labeled $A_X$. In accordance with embodiments discussed below, processing circuit 26 is configured to assess the functionality of first and second MEMS structures 28, 30 and detect a defective one of the first and second MEMS structures 28, 30, if present, by determining that first and second output signals 64, 66 are uncorrelated to one another. That is, since first and second MEMS structures 28, 30 are configured to detect the same physical stimulus (e.g., acceleration 23 in X-direction 22), first and second output signals 64, 66 should be generally equivalent within some nominal signal range. If one of first and second MEMS structures 28, 30 is defective (e.g., one of first and second MEMS structures 28, 30 is failing due to stiction, breakage, leakage due to particles, and so forth), first and second output signals 64, 66 will not correlate to one another. In some embodiments, if one of the first and second MEMS structures 28, 30 is determined to be defective, the defective MEMS structure is isolated from the remainder of the system and output signal 72 can be produced using only the output signals from the non-defective MEMS structure.

For simplicity of description, a single axis accelerometer is shown. In practice, however, the sensor device may be a two or three axis sensing device, in which each axis may have redundant channels. Further, first and second MEMS structures 28, 30 are capacitive transducers configured to sense linear acceleration. However, it should be understood that first and second MEMS structures 28, 30 may be any of a variety of transducers which may be independently configured to sense the desired physical stimulus (e.g., acceleration, angular velocity, pressure, and so forth). Still further, although configurations are described herein in which the redundant system includes only two MEMS structures, it should be understood that a redundant system may include more than two MEMS structures configured to sense the same physical stimulus along the same sense axis.

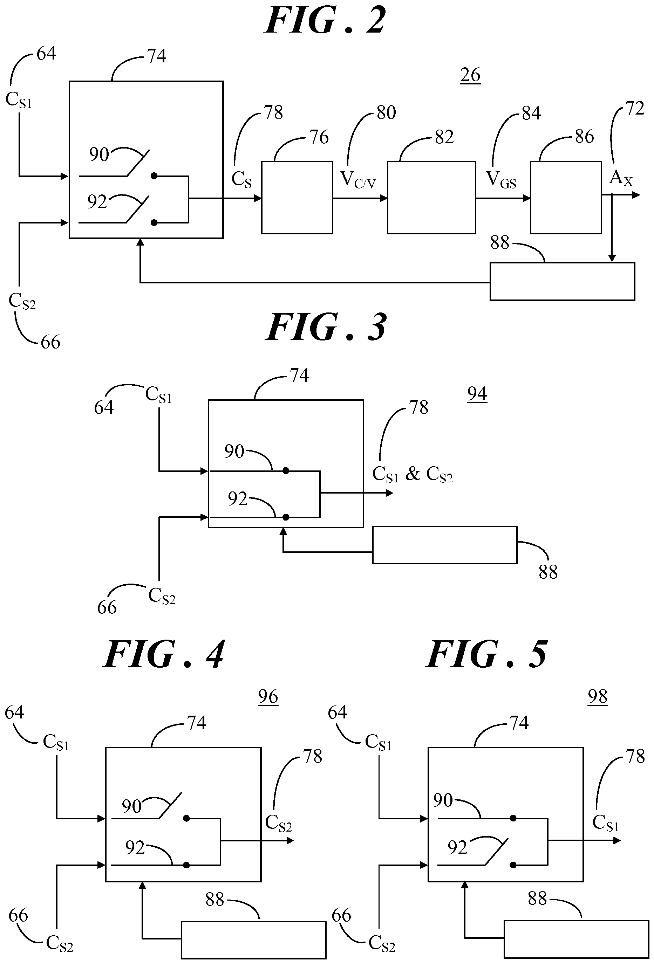

FIG. 2 shows a block diagram of processing circuit 26 of MEMS sensor system 20 (FIG. 1). Processing circuit 26 includes a signal control circuit 74 (SIGNAL CONTROL) having inputs connected to sensor device 24 (FIG. 1) for receiving first and second output signals 64, 66. In accordance with an embodiment, signal control circuit 74 is configured to isolate a defective one of the first and second MEMS structures 28, 30 from a remainder of the signal chain in response to detection of a failure in any one of the first and second MEMS structures 28, 30 (FIG. 1). The next stage of the signal chain may be a capacitance-to-voltage (C/V) converter 76 having an input connected to an output from signal control circuit 74 for receiving sensor output signals 78, labeled $C_S$, from signal control circuit 74 and converting them to one or more voltage output signals 80, labeled $V_{C/V}$. The next stage of the signal chain may be a gain stage 82 having an input connected to an output of C/V converter 76 for receiving voltage output signals 80 and producing gain adjusted output signals 84, labeled $V_{GS}$. Gain stage 82 may be configured to increase the gain of voltage output signals 80 when only one of first and second output signals 64, 66 is being processed (discussed below) to a nominal sensitivity for accelerometer 20. The next stage of the signal chain may be an analog-to-digital converter (ADC) 86 having an input connected to an output of gain stage 82 for receiving gain adjusted output signals 84 and converting signals 84 into a processed digital data stream, e.g. processed output signal 72, indicative of the sensed physical stimulus.

The simplified signal chain of processing circuit 26 (following signal control circuit 74) used to process first and second output signals 64, 66 to produce processed output signal 72, is provided for illustrative purposes. Those skilled in the art will recognize that the signal chain may include additional stages and/or different stages from that shown. For example, the signal chain may include an anti-aliasing filter stage for producing a bandwidth restricted output signal, a pre-filter stage, a chopper circuit stage, and so forth in accordance with a particular architecture. Additionally, the various inputs to and outputs from the stages are represented collectively by a single line for simplicity. Again, those skilled in the art will recognize that there may be multiple inputs and outputs in accordance with the particular architecture.

In accordance with some embodiments, processing circuit 26 further includes internal diagnostics circuitry 88, labeled DIAGNOSTICS. Diagnostics circuitry 88 is configured to detect a defective one of first and second MEMS structures 28, 30. In an example, signal control circuit 74 is represented by switches 90, 92. Diagnostics circuitry 88 may be a state-machine configured to receive first and second output signals 64, 66 in digital form (following analog-to-digital conversion at ADC 86), initiate a self-test sequence utilizing the digital form of first and second output signals 64, 66, and control the state of switches 90, 92 in response to the self-test sequence.

In an embodiment, signal control circuit 74 of processing circuit 26 may be readily and cost effectively incorporated at the analog front-end of processing circuit 26 and diagnostics circuitry 88 may be readily and cost effectively incorporated following ADC 86. Signal control circuit 74 and diagnostics circuitry 88 may be implemented in hardware, software, or any suitable combination of hardware and software for detecting a defective one of the first and second MEMS structures 28, 30 and isolating it from the remainder of the signal processing chain. In FIG. 2, signal control circuit 74 is represented by two switches 90, 92 for simplicity. However, circuitry forming switches 90, 92 and diagnostics circuitry 88 may include multiple switches, as well as a multiplicity of active and passive components for detecting and isolating a defective one of the first and second MEMS structures 28, 30 from the remainder of the signal processing chain. Switches 90, 92 are shown as being open for illustrative purposes. However, in operational practice, both of switches 90, 92 may be closed or only one of switches 90, 92 may be closed.

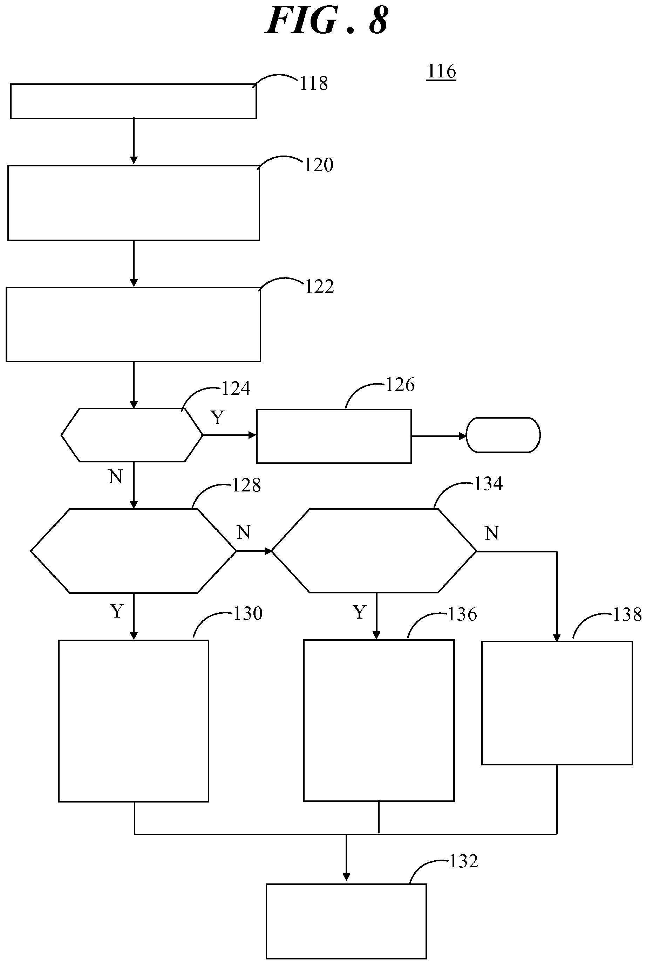

Referring to FIGs. 2 and 3, FIG. 3 shows a block diagram of signal control circuit 74 of processing circuit 26 of MEMS sensor system 20 in a nominal operational state 94 following self-test. As will be discussed in connection with methodology of FIG. 8 below, nominal operational state 94 entails utilizing both first and second output signals 64, 66 at the front-end of the signal processing chain of processing circuit 26 to yield processed output signal 72. Hence, in FIG. 3, both of switches 90, 92 are closed and sensor output signals 78, $C_S$, include the components of first and second output signals 64, 66 (e.g., $C_{S1}$ and $C_{S2}$).

Next referring to FIGs. 2 and 4, FIG. 4 shows a block diagram of signal control circuit 74 of processing circuit 26 of MEMS sensor system 20 in a first reduced function state 96 following self-test. In accordance with the methodology of FIG. 8 below, first reduced function state 96 entails detecting that first MEMS structure 30 is defective by determining that first output signal 64 is not correlated with second output signal 66. Thus, first MEMS structure 28, or more specifically, first output signal 64 from first MEMS structure 28 is isolated from the remainder of the signal processing chain of processing circuit 26. In FIG. 4, first reduced function state 96 is demonstrated by switch 90 being open and switch 92 being closed. Thus, sensor output signals 78, Cs, include only the components of second output signal 66 (e.g., $C_{S2}$). Accordingly, only the components of second output signal 66 will be processed to yield processed output signal 72.

Now referring to FIGs. 2 and 5, FIG. 5 shows a block diagram of signal control circuit 74 of processing circuit 26 of MEMS sensor system 20 in a second reduced function state 98 following self-test. In accordance with the methodology of FIG. 8 below, second reduced function state 98 entails detecting that second MEMS structure 30 is defective by determining that second output signal 66 is not correlated with first output signal 64. Thus, second MEMS structure 30, or more specifically, second output signal 66 from second MEMS structure 30 is isolated from the remainder of the signal processing chain of processing circuit 26. In FIG. 5, second reduced function state 98 is demonstrated by switch 90 being closed and switch 92 being open. Thus, sensor output signals 78, $C_S$, include only the components of first output signal 64 (e.g., $C_{S1}$). Accordingly, only the components of first output signal 64 will be processed to yield processed output signal 72.

The architecture demonstrated in FIGs. 2-5 enables the utilization of separate inputs from first and second MEMS structures 28, 30 for internal diagnostics and for mitigation of single point electromechanical failures in one of first and second MEMS structures 28, 30. Further, a reduced functionally mode may be enabled in which the output of a single channel 68, 70 (FIG. 1) may be provided to a user to allow a "limp home mode" if only part of sensor device 24 (FIG. 1) has failed. In a "limp home mode," system 20 (FIG. 1) may still function even if sensor output is degraded. That is, one of first and second channels 68, 70 (FIG. 1) may have worse performance in terms of, for example, noise performance, than the combined output, but would still provide some functionality.

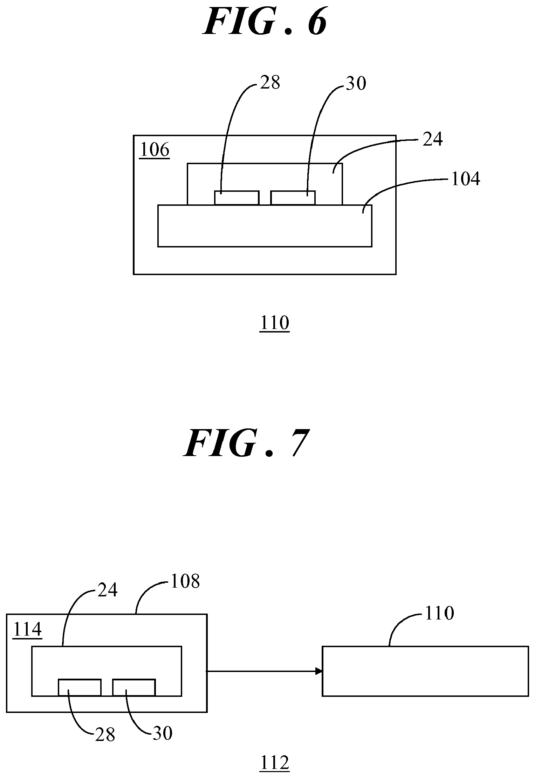

FIG. 6 shows a block diagram of a packaged MEMS sensor system 100 in accordance with an embodiment. Packaged MEMS sensor system 100 may include a sensor device 24 (MEMS) in the form of an individual sensor die and an application specific integrated circuit 104 (ASIC). Sensor device 24 and ASIC 104 may be encapsulated in, for example, a molding compound 106, that provides environmental protection for sensor device 24 and ASIC 104. Sensor device 24 includes first and second MEMS structures 28, 30 and ASIC 104 includes processing circuit 26 (FIG. 2) with signal control circuit 74 and diagnostics circuitry 88 (FIG. 2). Thus, packaged MEMS sensor system 100 represents a redundant sensor architecture configured to produce output signals in response to a physical stimulus, detect a defective one of the redundant sensors, produce a combined signal in nominal operational state 94 (FIG. 3) if neither of first and second MEMS structures 28, 30 is defective, or produce a non-combined signal (e.g. non-differential signal) in either of first and second reduced function states 96, 96 (FIGs. 4 and 5) in response to detection of a defective one of first and second MEMS structures 28, 30.

FIG. 7 shows a block diagram of a packaged MEMS sensor 108 electrically coupled with a separate end-user circuit 110 to form a sensor system 112. Packaged MEMS sensor 108 includes sensor device 24 in the form of an individual sensor die encapsulated in, for example, a molding compound 114 that provides environmental protection for sensor device 24. Sensor device 24 (FIG. 1) includes first and second MEMS structures 28, 30 and the physically separate end-user circuit 110 includes processing circuit 26 (FIG. 2) including signal control circuit 74 and diagnostics circuitry 88 (FIG. 2). Thus, packaged MEMS sensor 108 also represents a redundant sensor architecture configured to produce output signals in response to a physical stimulus. Further, end-user circuit 110 may be provided access to the output signals from first and second MEMS structures 28, 30 in order to detect a defective one of the redundant sensors, produce a combined signal in nominal operational state 94 (FIG. 3) if neither of first and second MEMS structures 28, 30 is defective, or produce a non-combined signal (e.g. non-differential signal) in either of first and second reduced function states 96, 98 (FIGs. 4 and 5) in response to detection of a defective one of first and second MEMS structures 28, 30.

Referring now to FIG. 8, FIG. 8 shows a flowchart of a method 116 of testing redundant MEMS structures in a MEMS sensor system in accordance with another embodiment. Method 116, alternatively referred to herein as a self-test process 116, may be executed in a redundant sensor system in accordance with the architectures described above. In general, method 116 can provide continuous failure detection monitoring for single point failures in a redundant sensor system during an operational scenario utilizing measurement signals from the redundant sensors. For clarity, method 116 will be described in connection with MEMS sensor system 20. Thus, reference should be made to FIGs. 1 and 2 in connection with the following description.

At a block 118, a self-test sequence is triggered. The self-test sequence may be triggered by user demand, periodically by diagnostic circuitry 88, or by any other suitable technique. At a block 120, diagnostics circuitry 88 receives first output signal 64 (in digital form) and performs diagnostics. For example, diagnostics circuitry 88 may suitably control the state of switches 90, 92 by closing switch 90 and opening switch 92 to enable only processing and digitization of first output signal 64. Diagnostics may entail evaluating whether first output signal 64 is within a nominal, or expected, signal range and/or any other signal evaluation techniques. At a block 122, diagnostics circuitry 88 receives second output signal 66 (in digital form) and again performs diagnostics. For example, diagnostics circuitry 88 may suitably control the state of switches 90, 92 by opening switch 90 and closing switch 92 to enable only processing and digitization of second output signal 66. Diagnostics may entail evaluating whether second output signal 66 is within the nominal, or expected, signal range and/or any other signal evaluation techniques. Further, diagnostics circuitry 88 may compare first and second output signals 64, 66 (in digital form) to one another. Since first and second MEMS structures 28, 30 are configured to produce first and second output signals 64, 66 in response to the same physical stimulus (e.g., acceleration 23), first and second output signals 64, 66 should be approximately equivalent and within the nominal signal range.

Process control continues with a decision block 124. At decision block 124, a determination is made as to whether there has been a critical failure within sensor system 20 (FIG. 1). For example, in response to the diagnostics performed at blocks 120, 122, diagnostics circuitry 88 may determine that both of first and second MEMS structures 28, 30 are defective, or some functional block within the signal processing chain of processing circuit 26 has failed. When a determination is made at decision block 124 that a critical failure has occurred, self-test process 116 may continue with a block 126. At block 126, a failure notification or flag may be issued to inform an end user or a downstream controller that sensor system 20 has had a critical failure. Thereafter, self-test process 116 may end. Thus, a critical failure may be identified that may not allow for nominal or partial functionality. As such the system may be disabled and/or the end user may be informed of the critical failure.

However, when a determination is made at decision block 124 that a critical failure has not occurred, process control continues with a decision block 128. Thus, a negative response at decision block 124 indicates that first and second MEMS structures 28, 30 may be operating nominally, or only one of first and second MEMS structures 28, 30 may be defective (e.g., a single point failure). Remaining operations of self-test process 116 are implemented to identify a single point failure and thereby enable partial functionality or to identify nominal operation and thereby enable fully differential functionality.

At decision block 128, a determination is made in response to the diagnostics performed at blocks 120, 122 as to whether first MEMS structure 28 is defective. For example, first output signal 64 may be outside of the nominal signal range for the sensor signals. Further, first output signal 64 may be uncorrelated to second output signal 66. Such a situation may arise when there is an electromechanical failure of only the first MEMS structure 28 (e.g., due to stiction, breakage, leakage due to particles, and so forth).

When a determination is made at decision block 128 that first MEMS structure 28 is defective, process control continues to a block 130. At block 130, signal control circuit 74 is configured in first reduced function state 96 (demonstrated in FIG. 4 by opening switch 90 and closing switch 92) in order to isolate the defective first MEMS structure 28 (and hence, first output signals 64) from the remainder of the signal processing chain such that only second output signals 66 are utilized. The signal processing chain of processing circuit 26 can therefore only process second output signal 66 to produce processed output signal 72. In some embodiments, gain stage 82 may double the gain of the voltage output signals 80 to compensate for the failure of first MEMS structure 28 so that the sensitivity of system 20 is close to nominal. However, in first reduced function state 96, the signal may be somewhat degraded in terms of noise performance. In this scenario, processed output signal 72 which has been produced from only second output signals 66 may be output at a block 132 to enable partial functionality (e.g., a "limp home mode" of operation).

Returning to decision block 128, when a determination is made that first MEMS structure 28 is not defective, then self-test process 116 continues with a decision block 134. At decision block 134, a determination is made in response to the diagnostics performed at blocks 120, 122 as to whether second MEMS structure 30 is defective. For example, second output signal 66 may be outside of the nominal signal range for the sensor signals. Further, second output signal 66 may be uncorrelated to first output signal 64. Such a situation may arise when there is an electromechanical failure of only the second MEMS structure 30 (e.g., due to stiction, breakage, leakage due to particles, and so forth).

When a determination is made at decision block 134 that second MEMS structure 30 is defective, process control continues with a block 136. At block 136, signal control circuit 74 is configured in second reduced function state 98 (demonstrated in FIG. 5 by closing switch 90 and opening switch 92) in order to isolate the defective second MEMS structure 30 (and hence second output signals 66) from the remainder of the signal processing chain such that only first output signals 64 are utilized. The signal processing chain of processing circuit 26 can therefore only process first output signal 64 to produce processed output signal 72. Again, in some embodiments, gain stage 82 may double the gain of the voltage output signals 80 to compensate for the failure of second MEMS structure 30 so that the sensitivity of system 20 is close to nominal. However, in second reduced function state 98, the signal may be somewhat degraded in terms of noise performance. Nevertheless, in this scenario, processed output signal 72 which has been produced from only first output signals 64 may be output at block 132 to enable partial functionality (e.g., a "limp home mode" of operation).

Returning to decision block 134, when a determination is made that second MEMS structure 30 is not defective, it can be concluded, or otherwise determined, that neither of first and second MEMS structures 28, 30 is defective. That is, first and second output signals 64, 66 are approximately equivalent and within the nominal signal range for the sensor signals. Process control continues with a block 138. At block 138, signal control circuit 74 is configured for nominal operational state 94 (demonstrated in FIG. 3 by closure of both switches 90, 92) such that both of first and second output signals 64, 66 will be utilized. The signal processing chain of processing circuit 26 can therefore suitably combine first and second output signals 64, 66 and at block 132, processed output signal 72 is output as a fully differential signal.

Thus, execution of self-test process 116 enables the detection of a single point failure in a redundant sensor system. The single point failure can be electromechanical damage to one of at least two sensor structures configured to detect the same physical stimulus. Further, the single point failure can be mitigated dynamically through reconfiguration of the analog front end of the processing circuit to isolate the failure and to produce a correct digital output signal, although at slightly degraded performance with respect to noise and potentially sensitivity.

It should be understood that execution of self-test process 116 may be periodically repeated (by user control or autonomously) in order to continuously monitor for faults in sensor system 20. Certain ones of the process blocks depicted in FIG. 8 may be performed in parallel with each other or with performing other processes. In addition, the particular ordering of the process blocks depicted in Fig. 8 may be modified, while achieving substantially the same result. Accordingly, such modifications are intended to be included within the scope of the inventive subject matter.

Embodiments disclosed herein entail redundant sensor systems and methodology for self-test of the redundant sensor systems. An embodiment of a method of testing first and second MEMS structures in a MEMS sensor system, the first MEMS structure being configured to produce a first output signal in response to a first physical stimulus and the second MEMS structure being configured to produce a second output signal in response to a second physical stimulus, the method comprising receiving the first and second output signals at a processing circuit and detecting a defective one of the first and second MEMS structures from the first and second output signals by determining that the first and second output signals are uncorrelated to one another.

In an example, the method further comprises utilizing only the first output signal (64) or the second output signal from a non-defective one of the first and second MEMS structures to produce a processed output signal when the detecting operation detects the defective one of the first and second MEMS structures.

In an example, the method further comprises increasing a voltage gain of the first output signal or the second output signal from the non-defective one of the first and second MEMS structures to a nominal sensitivity of the MEMS sensor system prior to produce the processed output signal.

In an example, the detecting the defective one of the first and second MEMS structures includes: determining that one of the first and second output signals is outside of a nominal signal range; and identifying the defective one of the first and second MEMS structures as producing the one of the first and second output signals outside of the nominal signal range.

In an example, the method further comprises determining that the other of the first and second output signals is within the nominal signal range, thereby indicating a single point failure.

In an example, the first and second MEMS structures are redundant MEMS structures such that the first physical stimulus and the second physical stimulus are a common physical stimulus.

In an example, the method further comprises determining that neither of the first and second MEMS structures is defective. The method further comprises utilizing both of the first and second output signals from the first and second MEMS structures to produce a processed output signal when neither of the first and second MEMS structures is defective.

In an example, the method is performed at the processing circuit. The first and second MEMS structures and the processing circuit are included in a single MEMS sensor package.

In an example, the first and second MEMS structures are included in a single MEMS die. The method is performed at the processing circuit provided in an end-user application that is separate from the single MEMS die.

An embodiment of MEMS sensor system comprises a first MEMS structure configured to produce a first output signal in response to a first physical stimulus, a second MEMS structure configured to produce a second output signal in response to a second stimulus, and a processing circuit configured to receive the first and second output signals and detect a defective one of the first and second MEMS structures from the first and second output signals by determining that the first and second output signals are uncorrelated to one another.

In an example, the processing circuit is further configured to utilize only the first output signal or the second output signal from a non-defective one of the first and second MEMS structures to produce a processed output signal.

In an example, the processing circuit comprises: a signal control circuit configured to receive the first and second output signals, enable output of the first output signal or the second output signal from the non-defective one of the first and second MEMS structures, and prevent output of the first output signal or the second output signal from the defective one of the first and second MEMS structures. The processing circuit comprises a signal processing chain including an analog-to-digital converter (ADC) for receiving the first output signal or the second output signal from the non-defective one of the first and second MEMS structures to produce the processed output signal.

In an example, the signal control circuit is further configured to enable output of both of the first and second output signals from the first and second MEMS structures when neither of the first and second MEMS structures is defective. The signal processing chain is configured to produce the processed output signal utilizing both of the first and second output signals when neither of the first and second MEMS structures is defective.

In an example, the first and second MEMS structures are redundant MEMS structures such that the first physical stimulus and the second physical stimulus are a common physical stimulus.

In an example, the first and second MEMS structures and the processing circuit are included in a single MEMS sensor package.

In an example, the first and second MEMS structures are included in a packaged MEMS sensor and the processing circuit is provided in an end-user application that is separate from the packaged MEMS sensor.

Another embodiment of testing first and second MEMS structures in a MEMS sensor system, the first MEMS structure being configured to produce a first output signal in response to a physical stimulus and the second MEMS structure being configured to produce a second output signal in response to the physical stimulus, the method comprising receiving the first and second output signals at a processing circuit, detecting a defective one of the first and second MEMS structures from the first and second output signals by determining that the first and second output signals are uncorrelated to one another, and utilizing only the first output signal or the second output signal from a non-defective one of the first and second MEMS structures to produce a processed output signal when the detecting operation detects the defective one of the first and second MEMS structures.

In an example, the detecting the defective one of the first and second MEMS structures includes: determining that one of the first and second output signals is outside of a nominal signal range; identifying the defective one of the first and second MEMS structures as producing the one of the first and second output signals outside of the nominal signal range; and prior to utilizing only the first output signal or the second output signal from the non-defective one of the first and second MEMS structures, determining that the other one of the first and second output signals is within the nominal signal range, thereby indicating a single point failure.

In an example, the method further comprises: determining that neither of the first and second MEMS structures is defective; and utilizing both of the first and second output signals from the first and second MEMS structures to produce the processed output signal when neither of the first and second MEMS structures is defective.

In an example, the method is performed at the processing circuit, and wherein the first and second MEMS structures and the processing circuit are included in a single MEMS sensor package.

Thus, embodiments described herein can utilize the separate output signals from redundant MEMS structures for self-test (e.g., internal diagnostics) and for mitigation of a single point electromechanical failure in one of the MEMS structures. In the instance of a single point electromechanical failure, the system and methodology can enable a reduced functionality mode of the sensor system. The self-test methodology may function autonomously to detect the mechanical failure of one of the MEMS structures and mitigate it dynamically through reconfiguration of the analog front end of the corresponding integrated circuit to isolate the defective MEMS structure and produce a processed digital output signal indicative of the output of the non-defective MEMS structure. Thus, the methodology may be implemented in a variety of redundant sensor systems in which the functionality of a redundant sensor system may be determined and failure mitigation may be performed with minimal impact to cost and complexity of the redundant sensor systems.

This disclosure is intended to explain how to fashion and use various embodiments in accordance with the invention rather than to limit the true, intended, and fair scope and spirit thereof. The foregoing description is not intended to be exhaustive or to limit the invention to the precise form disclosed. Modifications or variations are possible in light of the above teachings. The embodiment(s) was chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims, as may be amended during the pendency of this application for patent, and all equivalents thereof, when interpreted in accordance with the breadth to which they are fairly, legally, and equitably entitled.

**Claims**

1. A method (116) of testing first and second microelectromechanical systems (MEMS) structures (28, 30) in a MEMS sensor system (20), the first MEMS structure being configured to produce a first output signal (64) in response to a first physical stimulus (23) and the second MEMS structure (66) being configured to produce a second output signal in response to a second physical stimulus (23), the method comprising:

   receiving (120, 122) the first and second output signals at a processing circuit (26); and
   detecting (128, 134) a defective one of the first and second MEMS structures from the first and second output signals by determining that the first and second output signals are uncorrelated to one another.

2. The method (116) of claim 1, further comprising utilizing (130, 136) only the first output signal (64) or the second output signal (66) from a non-defective one of the first and second MEMS structures (28, 30) to produce a processed output signal (72) when the detecting operation (128, 134) detects the defective one of the first and second MEMS structures.

3. The method (116) of claim 2, further comprising increasing a voltage gain of the first output signal (64) or the second output signal (66) from the non-defective one of the first and second MEMS structures (28, 30) to a nominal sensitivity of the MEMS sensor system prior to produce the processed output signal (72)

4. The method (116) of any preceding claim, wherein the detecting (128, 134) the defective one of the first and second MEMS structures (28, 30) includes:

   determining (120, 122) that one of the first and second output signals (64, 66) is outside of a nominal signal range; and
   identifying (128, 134) the defective one of the first and second MEMS structures as producing the one of the first and second output signals outside of the nominal signal range.

5. The method (116) of claim 4, further comprising determining (128, 134) that the other of the first and second output signals (64, 66) is within the nominal signal range, thereby indicating a single point failure.

6. The method (116) of any preceding claim, wherein the first and second MEMS structures (28, 30) are redundant MEMS structures such that the first physical stimulus and the second physical stimulus are a common physical stimulus (23).

7. The method (116) of any preceding claim, further comprising:

   determining (134) that neither of the first and second MEMS structures (28, 30) is defective; and
   utilizing (138) both of the first and second output signals from the first and second MEMS structures to produce a processed output signal (72) when neither of the first and second MEMS structures is defective.

8. The method (116) any preceding of claim, wherein the method is performed at the processing circuit (26), and wherein the first and second MEMS structures (28, 30) and the processing circuit are included in a single MEMS sensor package (100).

9. The method (116) of any preceding claim, wherein the first and second MEMS structures (28, 30) are included in a single MEMS die (108), and the method is performed at the processing circuit (26) provided in an end-user application (110) that is separate from the single MEMS die.

10. A microelectromechanical systems (MEMS) sensor system (20), comprising:

a first MEMS structure (28) configured to produce a first output signal (64) in response to a first physical stimulus (23);
a second MEMS structure (30) configured to produce a second output signal (66) in response to a second physical stimulus (23); and
a processing circuit (26) configured to receive the first and second output signals and detect a defective one of the first and second MEMS structures from the first and second output signals by determining that the first and second output signals are uncorrelated to one another.

11. The MEMS sensor system (20) of claim 10, wherein the processing circuit (26) is further configured to utilize only the first output signal (64) or the second output signal (66) from a non-defective one of the first and second MEMS structures (28, 30) to produce a processed output signal (72).

12. The MEMS sensor system (20) of claim 11, wherein the processing circuit (26) comprises:

a signal control circuit (74) configured to receive the first and second output signals (64, 66), enable output of the first output signal (64) or the second output signal (66) from the non-defective one of the first and second MEMS structures (28, 30), and prevent output of the first output signal (64) or the second output signal (66) from the defective one of the first and second MEMS structures (28, 30); and
a signal processing chain including an analog-to-digital converter (ADC) for receiving the first output signal (64) or the second output signal (66) from the non-defective one of the first and second MEMS structures (28, 30) to produce the processed output signal (72).

13. The MEMS sensor system (20) of claim 12, wherein
signal control circuit (74) is further configured to enable output of both of the first and second output signals (64, 66) from the first and second MEMS structures (28, 30) when neither of the first and second MEMS structures is defective; and
the signal processing chain is configured to to produce the processed output signal (72) utilizing both of the first and second output signals (64, 66) when neither of the first and second MEMS structures is defective.

14. The MEMS sensor system (20) of any one of the claims 10 to 13, wherein the first and second MEMS structures (28, 30) are redundant MEMS structures such that the first physical stimulus and the second physical stimulus are a common physical stimulus (23).

15. The MEMS sensor system (20) of any one of the claims 10 to 14,
wherein the first and second MEMS structures (28, 30) and the processing circuit (26) are included in a single MEMS sensor package (100); or
wherein the first and second MEMS structures (28, 30) are included in a packaged MEMS sensor (108) and the processing circuit (26) is provided in an end-user application (110) that is separate from the packaged MEMS sensor (108).

# FIG. 1

20

## FIG. 2

## FIG. 3

## FIG. 4

## FIG. 5

# FIG . 6

28 30

106

24

104

110

# FIG . 7

24 108

114

110

28 30

112

# FIG. 8

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/225634 A1 (BROILLET BERNARD [CH]) 14 August 2014 (2014-08-14) * page 3, paragraph 42 - page 7, paragraph 100; figures 1-3 * | 1-15 | INV. G01P21/00 G01C25/00 |
| A | US 2016/069714 A1 (SCHEUING JAN [DE] ET AL) 10 March 2016 (2016-03-10) * the whole document * | 1-15 | |
| A | US 2014/318209 A1 (REIMANN MATHIAS [DE]) 30 October 2014 (2014-10-30) * the whole document * | 1-15 | |
| A | US 2014/352396 A1 (RAUH CHRISTIAN [DE] ET AL) 4 December 2014 (2014-12-04) * the whole document * | 1-15 | |
| A | US 6 625 527 B1 (DING EVE LIMIN [DE] ET AL) 23 September 2003 (2003-09-23) * the whole document * | 1-15 | |

TECHNICAL FIELDS
SEARCHED (IPC)

G01P
G01C
G01D

The present search report has been drawn up for all claims

| Place of search | Date of completion of the search | Examiner |
|---|---|---|
| Munich | 17 May 2019 | Springer, Oliver |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 30 6670

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2019

| Patent document cited in search report | | Publication date | Patent family member(s) | | Publication date |
|---|---|---|---|---|---|
| US 2014225634 | A1 | 14-08-2014 | BR | 102014003397 A2 | 20-10-2015 |
| | | | CA | 2839742 A1 | 14-08-2014 |
| | | | CN | 103994782 A | 20-08-2014 |
| | | | EP | 2767808 A1 | 20-08-2014 |
| | | | JP | 2014157154 A | 28-08-2014 |
| | | | US | 2014225634 A1 | 14-08-2014 |
| US 2016069714 | A1 | 10-03-2016 | CN | 104870943 A | 26-08-2015 |
| | | | DE | 102012222724 A1 | 12-06-2014 |
| | | | EP | 2932198 A1 | 21-10-2015 |
| | | | US | 2016069714 A1 | 10-03-2016 |
| | | | WO | 2014090445 A1 | 19-06-2014 |
| US 2014318209 | A1 | 30-10-2014 | CN | 103796880 A | 14-05-2014 |
| | | | DE | 102011080511 A1 | 07-02-2013 |
| | | | FR | 2978842 A1 | 08-02-2013 |
| | | | JP | 5851035 B2 | 03-02-2016 |
| | | | JP | 2014529064 A | 30-10-2014 |
| | | | US | 2014318209 A1 | 30-10-2014 |
| | | | WO | 2013020739 A1 | 14-02-2013 |
| US 2014352396 | A1 | 04-12-2014 | CN | 104040295 A | 10-09-2014 |
| | | | DE | 102011084784 A1 | 25-04-2013 |
| | | | EP | 2769184 A1 | 27-08-2014 |
| | | | JP | 6045596 B2 | 14-12-2016 |
| | | | JP | 2015500980 A | 08-01-2015 |
| | | | US | 2014352396 A1 | 04-12-2014 |
| | | | WO | 2013056966 A1 | 25-04-2013 |
| US 6625527 | B1 | 23-09-2003 | EP | 1154919 A1 | 21-11-2001 |
| | | | JP | 2002537549 A | 05-11-2002 |
| | | | US | 6625527 B1 | 23-09-2003 |
| | | | WO | 0048883 A1 | 24-08-2000 |

EPO FORM P0459

For more details about this annex : see Official Journal of the European Patent Office, No. 12/82